# EUROPEAN PATENT APPLICATION

(11) **EP 4 044 254 A2**
(43) Date of publication of application: **17.08.2022**
(21) Application number: 22151711.3
(22) Date of filing: 17.01.2022
(51) Int. Cl.: H01L 29/78, H01L 29/06, H01L 29/08, H01L 23/00, H01L 21/336

(54) **SEMICONDUCTOR DEVICE AND SEMICONDUCTOR PACKAGE**

(30) Priority: 22.01.2021 JP 2021008604
(71) Applicant: Renesas Electronics Corporation, Tokyo 135-0061 (JP)
(72) Inventor: NAKASHIBA, Yasutaka, Tokyo, 135-0061 (JP); SHIMOMURA, Akihiro, Tokyo, 135-0061 (JP); SAWADA, Masami, Tokyo, 135-0061 (JP)
(74) Representative: Betten & Resch

(57) **Abstract**

The semiconductor device according to one embodiment includes a semiconductor substrate having a first surface and a second surface on an opposite side of the first surface, a gate insulating film formed on the first surface, a gate formed on the first surface via the gate insulating film, a source region formed in the first surface side of the semiconductor substrate, a body region formed so as to be in contact with the source region and including a channel region, a drain region formed in the second surface side of the semiconductor substrate, and a drift region formed so as to be in contact with the second surface side of the body region and the first surface side of the drain region. The semiconductor substrate has at least one concave portion formed in the second surface and being recessed toward the first surface.

## Description

### CROSS-REFERENCE TO RELATED APPLICATIONS

The disclosure of Japanese Patent Application No. 2021-008604 filed on January 22, 2021 including the specification, drawings and abstract is incorporated herein by reference in its entirety.

### BACKGROUND

The present invention relates to a semiconductor device and a semiconductor package.

### There are disclosed techniques listed below.

[Patent Document 1] U.S. Patent No. 5,998,833

Patent Document 1 discloses a semiconductor device having a semiconductor substrate, a gate insulating film, and a gate. The semiconductor substrate has a first surface and a second surface. The second surface is an opposite surface to the first surface. The semiconductor substrate has a source region located in the first surface, a drain region located in the second surface, a drift region in contact with the first surface side of the drain region, and a base region including a channel region sandwiched between the source region and the drift region.

A gate trench is formed in the first surface. A bottom wall of the gate trench is located in the drift region. A channel region is exposed from a side wall of the gate trench. A gate insulating film is formed on the side wall and on the bottom wall of the gate trench. The gate is arranged inside the gate trench so as to face the channel region with the gate insulating film interposed therebetween.

### SUMMARY

In the semiconductor device disclosed in Patent Document 1, as a measure to reduce an ON resistance, it is considered to form a thin drain region by polishing the semiconductor substrate from the second surface side. However, in this case, the entire semiconductor substrate would become thin, and as a result, handling ability in the manufacturing process is deteriorated.

The present invention provides a semiconductor device capable of maintaining the handling ability in the manufacturing process while reducing the ON resistance.

The semiconductor device according to one embodiment comprises a semiconductor substrate having a first surface and a second surface on an opposite side of the first surface, a gate insulating film formed on the first surface, a gate formed on the first surface via the gate insulating film, a source region formed on the first surface side of the semiconductor substrate, a body region formed so as to be in contact with the source region and including a channel region, a drain region formed on the second surface side of the semiconductor substrate, and a drift region formed so as to be in contact with the second surface side of the body region and the first surface side of the drain region. The gate faces the channel region with the gate insulating film interposed therebetween. The semiconductor substrate has at least one concave portion formed in the second surface and being recessed toward the first surface.

According to the semiconductor device of one embodiment, it is possible to maintain the handling ability in the manufacturing process while reducing the ON resistance.

### BRIEF DESCRIPTION OF THE DRAWINGS

FIG. 1 is a plan view of a semiconductor device DEV1.
FIG. 2 is a cross-sectional view taken along a line II-II of FIG. 1.
FIG. 3 is an enlarged view of a region III of FIG. 2.
FIG. 4 is a cross-sectional view taken along a line IV-IV of FIG. 1.
FIG. 5 is a flowchart of a manufacturing method of the semiconductor device DEV1.
FIG. 6 is a cross-sectional view of the semiconductor device DEV1 in a preparation step S1.
FIG. 7 is a cross-sectional view of the semiconductor device DEV1 in an epitaxial growth step S2.
FIG. 8 is a cross-sectional view of the semiconductor device DEV1 in a first ion implantation step S3.
FIG. 9 is a cross-sectional view of a semiconductor device DEV2 in a second ion implantation step S4.
FIG. 10 is a cross-sectional view of the semiconductor device DEV1 in a trench formation step S5.
FIG. 11 is a cross-sectional view of the semiconductor device DEV1 in a gate insulating film formation step S6.
FIG. 12 is a cross-sectional view of the semiconductor device DEV1 in a gate formation step S7.
FIG. 13 is a cross-sectional view of the semiconductor device DEV1 in an interlayer insulating film formation step S8.
FIG. 14 is a cross-sectional view of the semiconductor device DEV1 in a substrate polishing step S10.
FIG. 15 is a cross-sectional view of the semiconductor device DEV1 in a concave portion formation step S11.
FIG. 16 is a cross-sectional view of the semiconductor device DEV1 in a first electrode formation step S12.
FIG. 17 is a cross-sectional view of the semiconductor device DEV1 in a second electrode formation step S13.
FIG. 18 is a cross-sectional view of the semiconductor device DEV1 according to a first modification example.
FIG. 19 is a cross-sectional view of the semiconductor device DEV1 according to a second modification example.
FIG. 20 is a cross-sectional view of the semiconductor device DEV1 according to a third modification example.
FIG. 21 is a bottom view of the semiconductor device DEV2.
FIG. 22 is a cross-sectional view taken along a line XXII-XXII of FIG. 21.
FIG. 23 is a bottom view of the semiconductor device DEV2 according to the first modification example.
FIG. 24 is a bottom view of the semiconductor device DEV2 according to the second modification example.
FIG. 25 is a bottom view of the semiconductor device DEV2 according to the third modification example.
FIG. 26 is a bottom view of a semiconductor device DEV3.
FIG. 27 is a cross-sectional view taken along a line XXVII-XXVII of FIG. 26.
FIG. 28 is a cross-sectional view of a semiconductor device DEV4.
FIG. 29 is a cross-sectional view of a semiconductor package PKG1.
FIG. 30 is a cross-sectional view of a semiconductor package PKG2.

### DETAILED DESCRIPTION

Hereinafter, details of embodiments of the present invention will be described with reference to the drawings. In all of the accompanying drawings, the same or corresponding members are denoted by the same reference signs, and redundant descriptions thereof are omitted as appropriate.

### (First Embodiment)

Hereinafter, a semiconductor device according to a first embodiment (hereinafter referred to as "semiconductor device DEV1") will be described.

### <Configuration of Semiconductor Device DEV1>

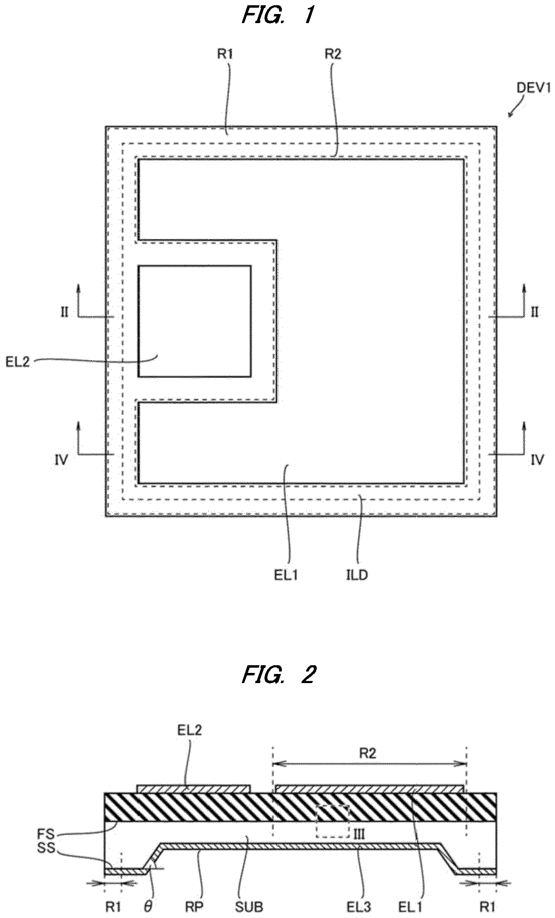

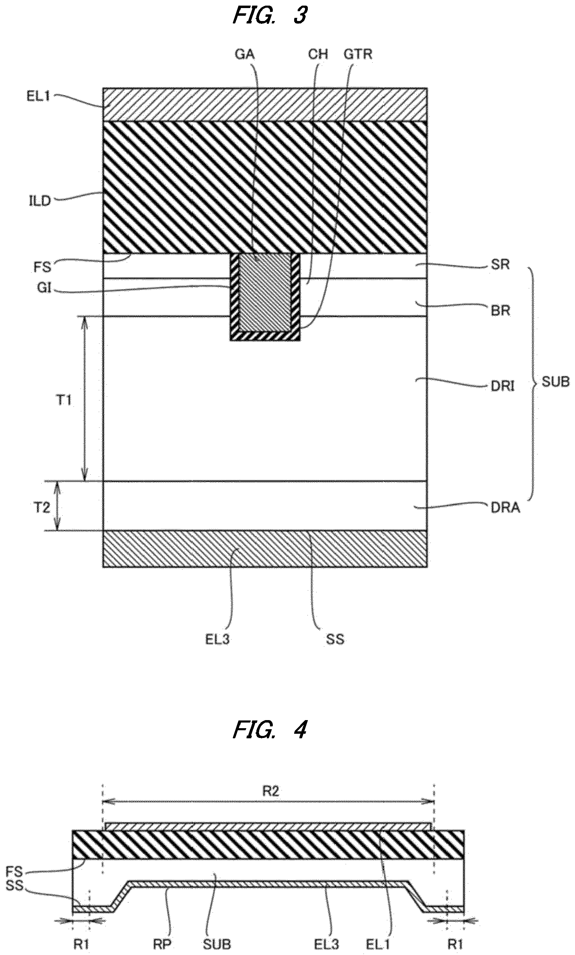

FIG. 1 is a plan view of the semiconductor device DEV1. FIG. 2 is a cross-sectional view taken along a line II-II of FIG. 1. FIG. 3 is an enlarged view of a region III of FIG. 2. FIG. 4 is a cross-sectional view taken along a line IV-IV of FIG. 1. As shown in FIGS. 1 to 4, the semiconductor device DEV1 has a semiconductor substrate SUB, a gate insulating film GI, a gate GA, an interlayer insulating film ILD, a source electrode EL1, a gate electrode EL2, and a drain electrode EL3.

The semiconductor substrate SUB has a first surface FS and a second surface SS. The first surface FS and the second surface SS are end surfaces in a thickness direction of the semiconductor substrate SUB. The second surface SS is an opposite surface to the first surface FS.

In plan view (or when viewed from a direction orthogonal to the first surface FS and the second surface SS), the semiconductor substrate SUB has an outer peripheral region R1 and a cell region R2. The outer peripheral region R1 is a portion located at an outer periphery of the semiconductor substrate SUB in plan view. In plan view, the cell region R2 is located inside the outer peripheral region R1. The cell region R2 is a portion where a cell structure of a MOSFET (Metal Oxide Field-Effect Transistor) is formed.

In the cell region R2, the semiconductor substrate SUB has a source region SR, a drain region DRA, a drift region DRI, and a body region BR. A conductivity type of each of the source region SR, the drain region DRA and the drift region DRI is a first conductivity type. A conductivity type of the body region BR is a second conductivity type. The second conductivity type is a conductivity type opposite to the first conductivity type. For example, in a case where the first conductivity type is n type, the second conductivity type is p type. An impurity concentration in each of the source region SR and the drain region DRA is higher than an impurity concentration in the drift region DRI.

The source region SR is located in the first surface FS. The drain region DRA is located in the second surface SS. The drift region DRI is formed on the drain region DRA. Namely, the drift region DRI is in contact with the first surface FS side of the drain region DRA. The body region BR is sandwiched between the source region SR and the drift region DRI.

In the cell region R2, a gate trench GTR is formed in the first surface FS. The gate trench GTR extends toward the second surface SS. A bottom wall of the gate trench GTR is located in the drift region DRI. The source region SR, the body region BR and the drift region DRI are exposed from a side wall of the gate trench GTR. A portion of the body region BR exposed from the gate trench GTR is defined as a channel region CH.

In the cell region R2, a concave portion RP is formed in the second surface SS. In the concave portion RP, the second surface SS is recessed toward the first surface FS side. As shown in FIG. 3, a portion of the concave portion RP may be formed in the second surface SS located outside the cell region R2. However, the concave portion RP is not formed in the second surface SS located in the outer peripheral region R1.

The semiconductor substrate SUB is formed of, for example, a single-crystal silicon. The first surface FS and the second surface SS are preferably orthogonal to a <100> direction of the single-crystal silicon. A side wall of the concave portion RP is at an angle θ with respect to the second surface SS. The angle θ is preferably 50 degrees or more and 60 degrees or less. The side wall of the concave portion RP is preferably orthogonal to a <111> direction of the single-crystal silicon. In the single-crystal silicon, an angle between the <100> direction and the <111> direction is approximately 55 degrees, and more specifically is 54.7 degrees.

A thickness of the drift region DRI is defined as a thickness T1. A thickness of the drain region DRA in a portion where the concave portion RP is formed is defined as a thickness T2. A thickness of the drain region DRA in a portion where the concave portion RP is not formed (that is, the outer peripheral region R1) is defined as a thickness T3. The thickness T2 is smaller than the thickness T3. Namely, the semiconductor substrate SUB has a sufficient thickness in the outer peripheral region R1.

The gate insulating film GI is arranged on the side wall and on the bottom wall of the gate trench GTR. The gate insulating film GI is formed of, for example, silicon oxide. The gate GA is arranged in the gate trench GTR. The gate insulating film GI is interposed between the gate GA and the side wall and the bottom wall of the gate trench GTR. Namely, the gate GA faces the channel region CH while being insulated by the gate insulating film GI. The gate GA is formed of, for example, polysilicon.

The interlayer insulating film ILD is arranged on the first surface FS. The interlayer insulating film ILD is formed of, for example, silicon oxide.

The source electrode EL1 and the gate electrode EL2 are arranged on the interlayer insulating film ILD. The source region SR and the gate GA are respectively and electrically connected to the source electrode EL1 and the gate electrode EL2 by contact plugs (not shown) formed in the interlayer insulating film ILD. The source electrode EL1 is arranged so as to overlap the cell region R2. The gate electrode EL2 is arranged so as to not overlap the cell region R2. The drain electrode EL3 is formed on the second surface SS. The source electrode EL1, the gate electrode EL2 and the drain electrode EL3 are formed of, for example, aluminum.

### <Manufacturing Method of Semiconductor Device DEV1>

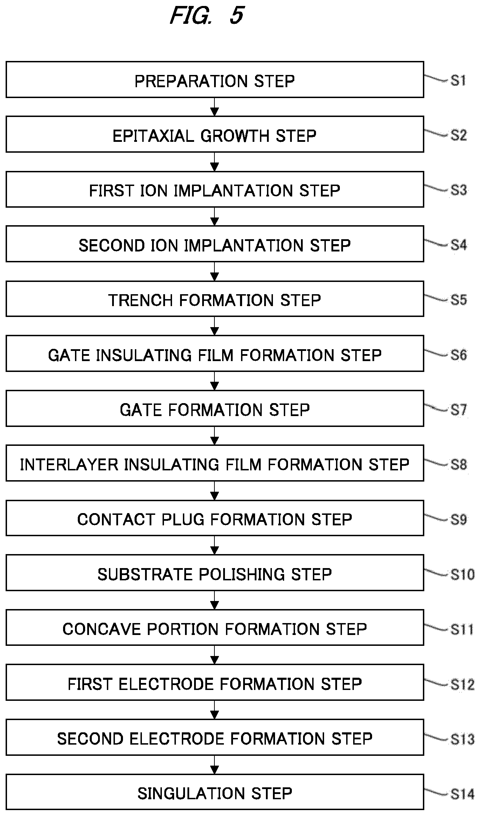

FIG. 5 is a flowchart of a manufacturing method of the semiconductor device DEV1. As shown in FIG. 5, the manufacturing method of the semiconductor device DEV1 includes a preparation step S1, an epitaxial growth step S2, a first ion implantation step S3, a second ion implantation step S4, a trench formation step S5, a gate insulating film formation step S6, a gate formation step S7, an interlayer insulating film formation step S8, and a contact plug formation step S9. The manufacturing method of the semiconductor device DEV1 further includes a substrate polishing step S10, a concave portion formation step S11, a first electrode formation step S12, a second electrode formation step S13, and a singulation step S14. The first ion implantation step S3 and the second ion implantation step S4 may be performed after the trench formation step S5, the gate insulating film formation step S6 and the gate formation step S7.

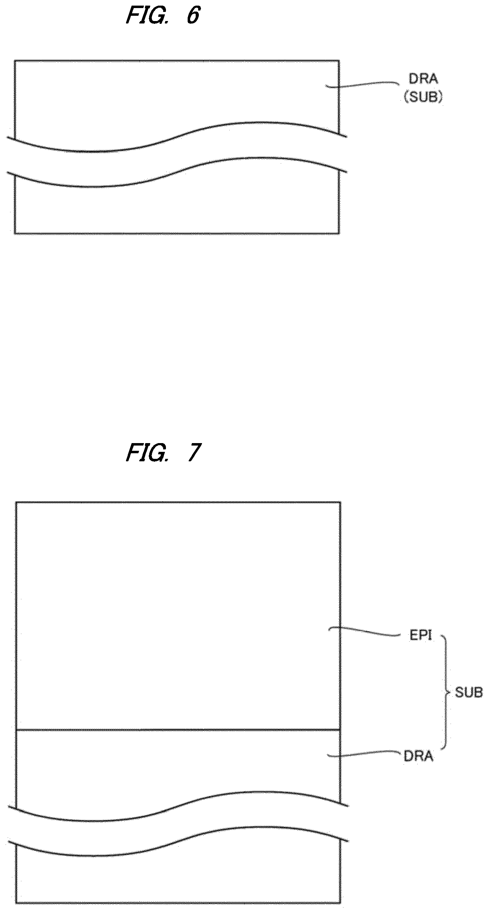

In the preparation step S1, the semiconductor substrate SUB is prepared. FIG. 6 is a cross-sectional view of the semiconductor device DEV1 in the preparation step S1. As shown in FIG. 6, the semiconductor substrate SUB prepared in the preparation step S1 has only the drain region DRA.

In the epitaxial growth step S2, an epitaxial layer EPI is formed. FIG. 7 is a cross-sectional view of the semiconductor device DEV1 in the epitaxial growth step S2. As shown in FIG. 7, the epitaxial layer EPI is formed on the drain region DRA. The epitaxial layer EPI has the first conductivity type. The epitaxial layer EPI is formed by, for example, a CVD (Chemical Vapor Deposition) method.

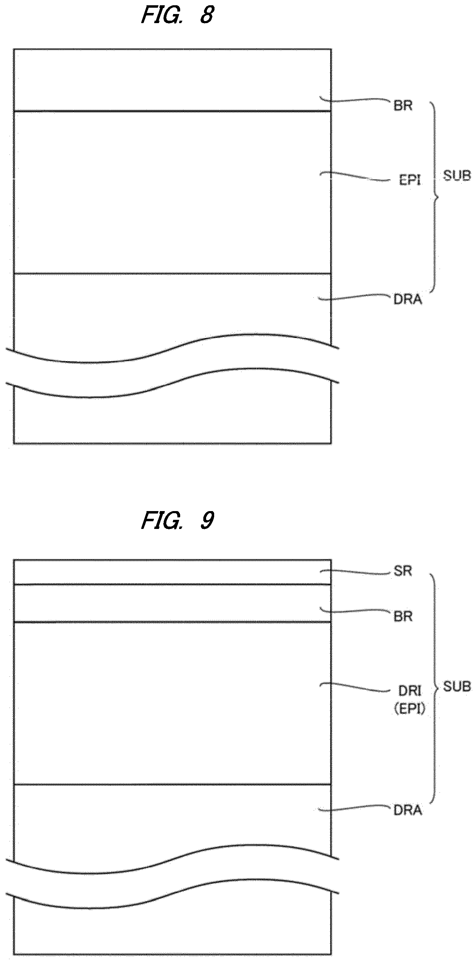

FIG. 8 is a cross-sectional view of the semiconductor device DEV1 in the first ion implantation step S3. As shown in FIG. 8, in the first ion implantation step S3, the body region BR is formed. FIG. 9 is a cross-sectional view of a semiconductor device DEV2 in the second ion implantation step S4. As shown in FIG. 9, in the second ion implantation step S4, the source region SR is formed. The body region BR and the source region SR are formed by performing ion implantation. A portion of the epitaxial layer EPI where the body region BR and the source region SR are not formed becomes the drift region DRI.

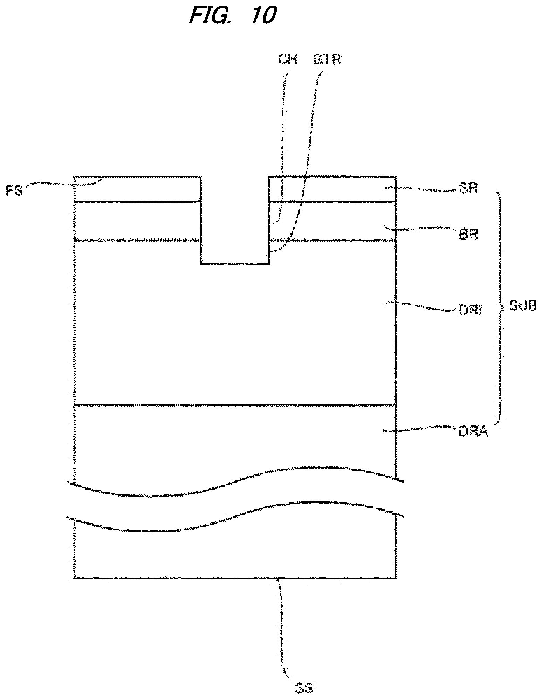

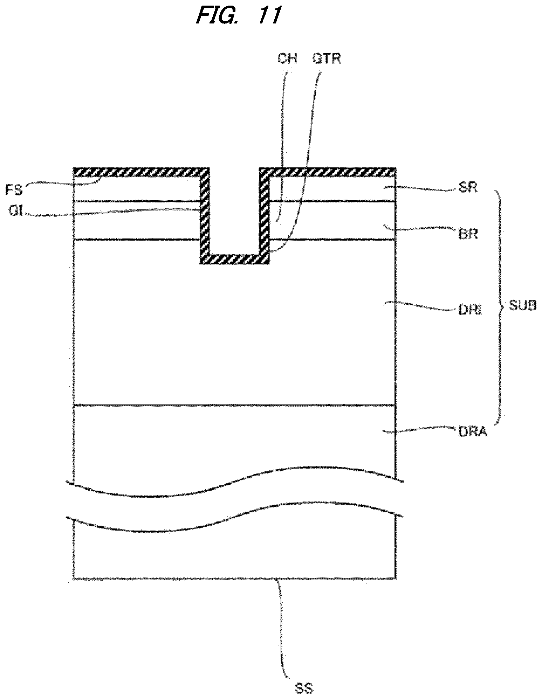

FIG. 10 is a cross-sectional view of the semiconductor device DEV1 in the trench formation step S5. As shown in FIG. 10, in the trench formation step S5, the gate trench GTR is formed. The gate trench GTR is formed by performing, for example, dry etching such as RIE (Reactive Ion Etching) . FIG. 11 is a cross-sectional view of the semiconductor device DEV1 in the gate insulating film formation step S6. As shown in FIG. 11, in the gate insulating film formation step S6, the gate insulating film GI is formed. The gate insulating film GI is formed by performing, for example, thermal oxidation.

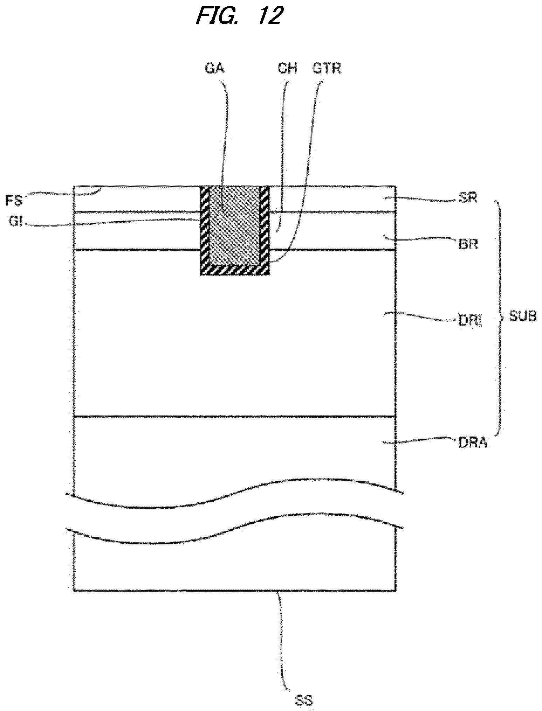

FIG. 12 is a cross-sectional view of the semiconductor device DEV1 in the gate formation step S7. As shown in FIG. 12, in the gate formation step S7, the gate GA is formed. When forming the gate GA, first, a material constituting the gate GA is embedded in the gate trench GTR. Next, the material constituting the gate GA and overflowing from the gate trench GTR is removed by etch back, CMP (Chemical Mechanical Polishing), or the like.

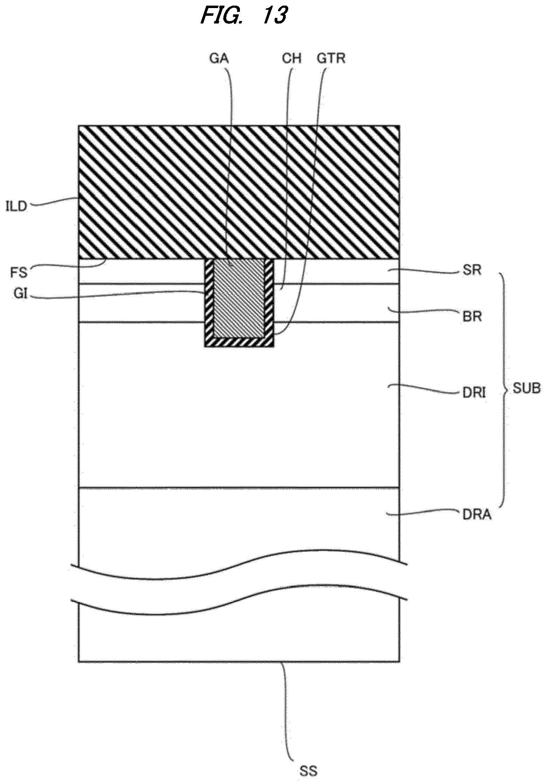

FIG. 13 is a cross-sectional view of the semiconductor device DEV1 in the interlayer insulating film formation step S8. As shown in FIG. 13, in the interlayer insulating film formation step S8, the interlayer insulating film ILD is formed. The interlayer insulating film ILD is formed by performing, for example, the CVD method.

In the contact plug formation step S9, the contact plug is formed. When forming the contact plug, first, a contact hole is formed in the interlayer insulating film ILD. The contact hole penetrates the interlayer insulating film ILD along the thickness direction. The contact hole is formed by performing, for example, dry etching such as RIE. Next, a material constituting the contact plug is embedded in the contact hole by the CVD method. Then, the material constituting the contact plug and overflowing from the contact hole is removed by etch back, CMP, or the like.

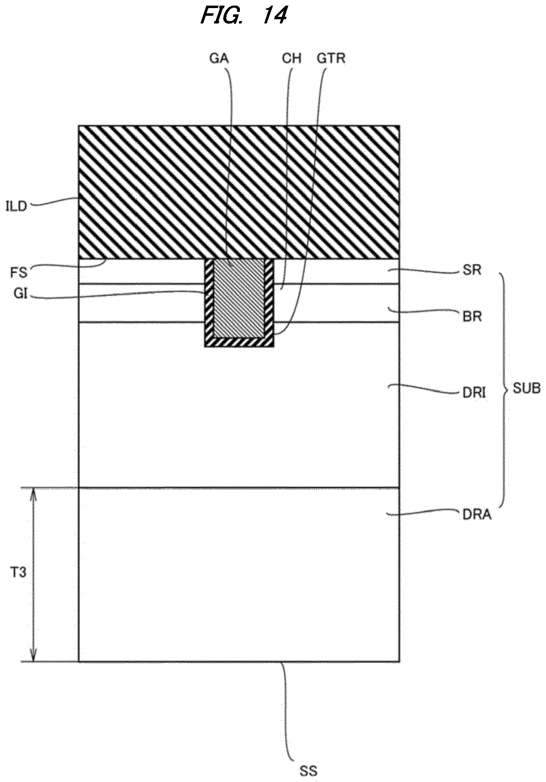

FIG. 14 is a cross-sectional view of the semiconductor device DEV1 in the substrate polishing step S10. As shown in FIG. 14, in the substrate polishing step S10, polishing is performed on the second surface SS side of the semiconductor substrate SUB. As a result, the thickness of the drain region DRA becomes the thickness T3.

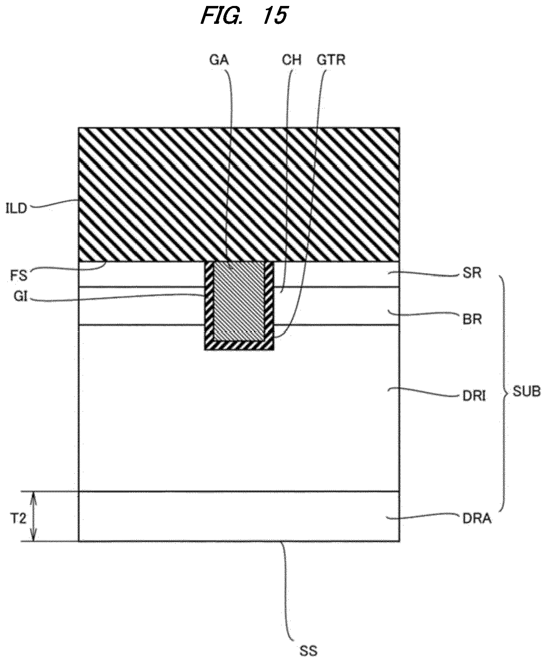

FIG. 15 is a cross-sectional view of the semiconductor device DEV1 in the concave portion formation step S11. As shown in FIG. 15, in the concave portion formation step S11, the concave portion RP is formed. When forming the concave portion RP, first, a mask is formed on the second surface SS. The mask is formed by, for example, forming a film of silicon oxide on the second surface SS by CVD or the like, and patterning the formed film of silicon oxide.

Next, the semiconductor substrate SUB is etched from an opening in the mask to form the concave portion RP. Etching is preferably performed by wet etching using tetramethylammonium hydroxide (TMAH). In a case where wet etching using TMAH is performed on the single-crystal silicon, an etching rate significantly differs between crystal orientations. Therefore, in a case where the second surface SS is orthogonal to the <100> direction of the single-crystal silicon, the surface orthogonal to the <111> direction of the single-crystal silicon is exposed from the side wall of the concave portion RP, and the angle θ becomes 50 degrees or more and 60 degrees or less.

As a result of the concave portion formation step S11, the drain region DRA becomes thin in the portion where the concave portion RP is formed, and the thickness T3 of the drain region DRA becomes the thickness T2. Namely, as a result of the concave portion formation step S11, the thickness of the drain region DRA at the position where the concave portion RP is formed becomes thinner than at the position where the concave portion RP is not formed (that is, the outer peripheral region R1).

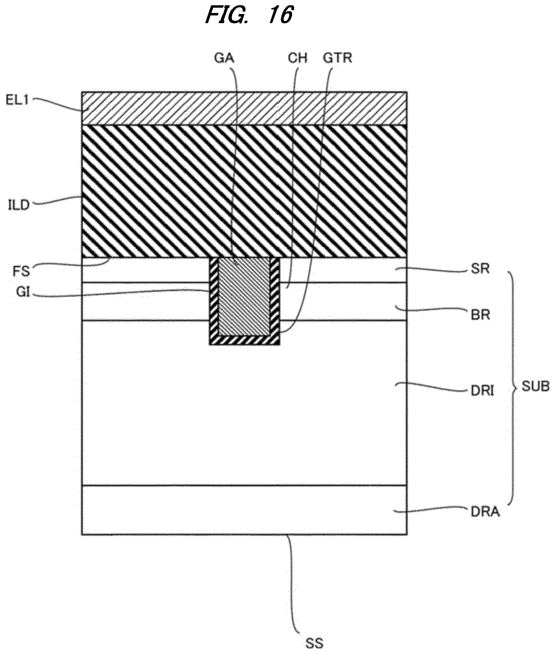

FIG. 16 is a cross-sectional view of the semiconductor device DEV1 in the first electrode formation step S12. As shown in FIG. 16, in the first electrode formation step S12, the source electrode EL1 and the gate electrode EL2 are formed.

When forming the source electrode EL1 and the gate electrode EL2, first, a material constituting the source electrode EL1 (gate electrode EL2) is deposited on the interlayer insulating film ILD by sputtering or the like. Next, the deposited material constituting the source electrode EL1 (gate electrode EL2) is patterned to form the source electrode EL1 and the gate electrode EL2.

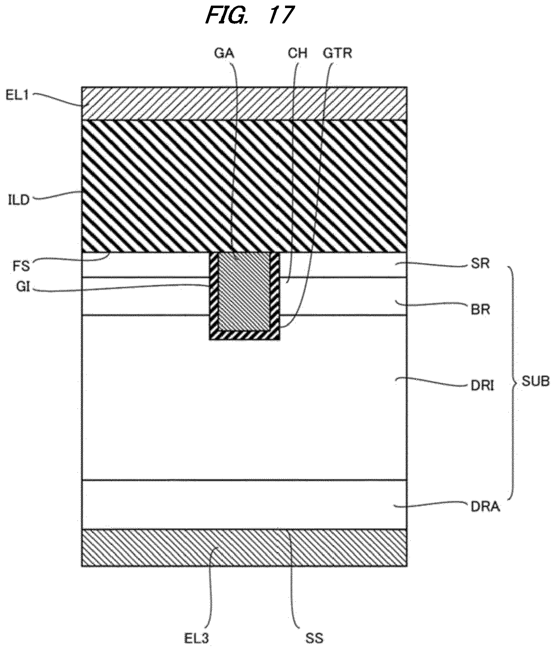

FIG. 17 is a cross-sectional view of the semiconductor device DEV1 in the second electrode formation step S13. As shown in FIG. 17, in the second electrode formation step S13, the drain electrode EL3 is formed. The drain electrode EL3 is formed by performing, for example, a sputtering method, a plating method, or the like. In the singulation step S14, singulation of the semiconductor device DEV1 is performed. The singulation is performed by using, for example, a dicing blade. In this manner, the semiconductor device DEV1 having a structure shown in FIGS. 1 to 4 is manufactured.

### <Effects of Semiconductor Device DEV1>

In the semiconductor device DEV1, since the thickness of the drain region DRA is thin in the portion where the concave portion RP is formed, the ON resistance is reduced. For example, when the thickness of the drift region DRI is 5 µm, a resistivity of the drift region DRI is 0.12 Ω·cm, a resistivity of the drain region DRA is 0.8 mΩ·cm, and the concave portion RP is formed to make the thickness of the drain region DRA from 150 µm to 5 µm, it is possible to reduce the ON resistance by about 20 percent (in a case where the thickness of the drain region DRA is 150 µm, the ON resistance becomes 0.12 Ω·cm × 5 µm + 0.8 mΩ·cm × 150 µm ≈ 7.2 mΩ·mm², and in a case where the thickness of the drain region DRA is reduced to 5 µm, the ON resistance becomes 0.12 Ω·cm × 5 µm + 0.8 mΩ × 5 µm ≈ 6.0 mΩ·mm²).

On the other hand, since the thickness of the drain region DRA is maintained in the portion where the concave portion RP is not formed (that is, in the outer peripheral region R1), the handling ability in the manufacturing process is maintained.

Namely, in a case where the thickness of the concave portion RP in the outer peripheral region R1 is thin, it would be difficult to use the dicing blade to cut the semiconductor substrate SUB in the singulation step S14. However, in the semiconductor device DEV1, since the thickness of the drain region DRA in the outer peripheral region R1 is maintained, it is possible to use the dicing blade to cut the semiconductor substrate SUB. Thus, according to the semiconductor device DEV1, it is possible to maintain the handling ability in the manufacturing process while reducing the ON resistance.

In a case where the second surface SS is orthogonal to the <100> direction of the single-crystal silicon, the angle θ can be made to be 50 degrees or more and 60 degrees or less by performing wet etching using TMAH on the concave portion RP. Namely, in this case, a tapered concave portion RP can be formed. As a result, when forming the drain electrode EL3, it is possible to suppress the drain electrode EL3 from becoming locally thin (in which step disconnection occurs in the drain electrode EL3).

### <First Modification Example>

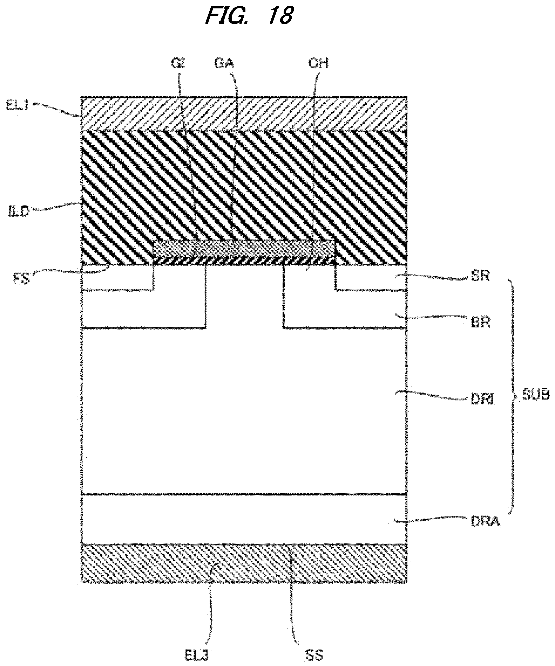

FIG. 18 is a cross-sectional view of the semiconductor device DEV1 according to a first modification example. As shown in FIG. 18, the gate trench GTR need not be formed in the semiconductor substrate SUB. Namely, the semiconductor device DEV1 may be a planar-gate type MOSFET instead of a trench-gate type MOSFET. In the first modification example, the gate insulating film GI is arranged on the channel region CH exposed on the first surface FS, and the gate GA is arranged on the gate insulating film GI.

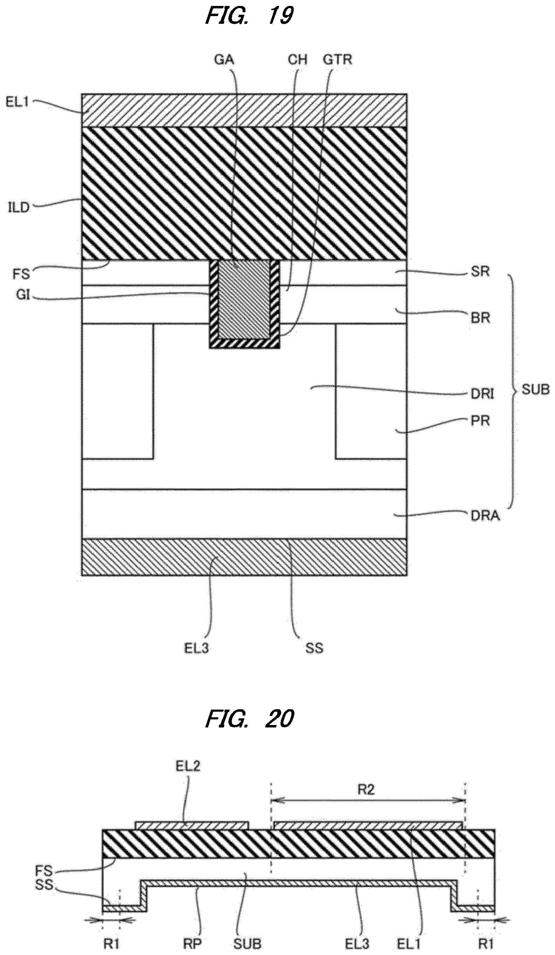

FIG. 19 is a cross-sectional view of the semiconductor device DEV1 according to a second modification example. As shown in FIG. 19, the semiconductor substrate SUB may have a pillar region PR. The pillar region PR extends from the body region BR toward the second surface SS side. The conductivity type of the pillar region PR is the second conductivity type (p type). Namely, the semiconductor device DEV1 may be a MOSFET having a superjunction structure. In this case, since the impurity concentration of the drift region DRI is set to be relatively high, the effect of reducing the ON resistance by having a thin drain region DRA at the position where the concave portion RP becomes relatively large.

The first surface FS and the second surface SS are orthogonal to the <110> direction of the single-crystal silicon. FIG. 20 is a cross-sectional view of the semiconductor device DEV1 according to a third modification example. In this case, as shown in FIG. 20, the angle θ becomes approximately 90 degrees by performing wet etching using TMAH on the concave portion RP.

### (Second Embodiment)

Hereinafter, a semiconductor device according to a second embodiment (hereinafter referred to as "semiconductor device DEV2") will be described. Here, points that differ from the semiconductor device DEV1 will be mainly described, and redundant descriptions will be omitted as appropriate.

### <Configuration of Semiconductor Device DEV2>

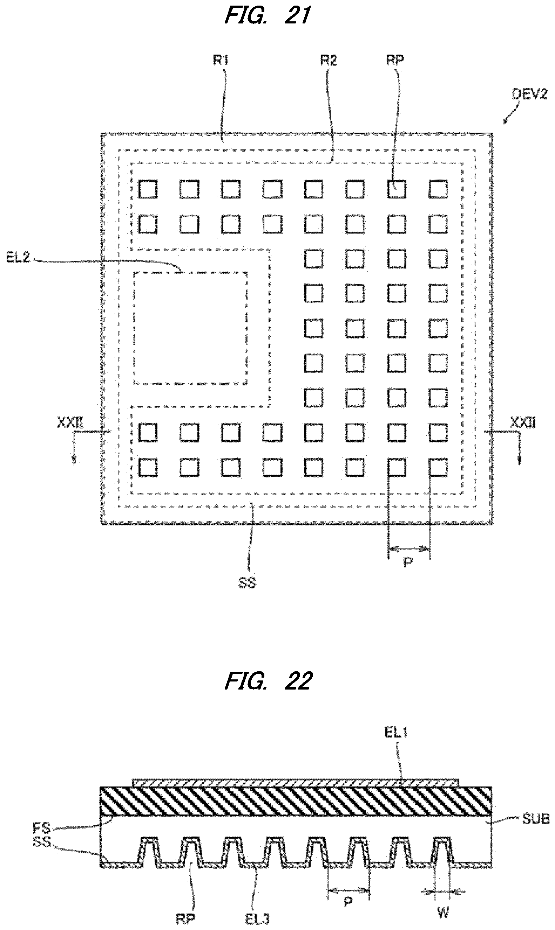

FIG. 21 is a bottom view of the semiconductor device DEV2. FIG. 22 is a cross-sectional view taken along a line XXII-XXII of FIG. 21. As shown in FIGS. 21 and 22, the semiconductor device DEV2 has the semiconductor substrate SUB, the gate insulating film GI, the gate GA, the interlayer insulating film ILD, the source electrode EL1, the gate electrode EL2, and the drain electrode EL3. In the cell region R2, the concave portion RP is formed in the second surface SS. In this regard, the configuration of the semiconductor device DEV2 is common to the configuration of the semiconductor device DEV1.

The semiconductor device DEV2 has a plurality of the concave portions RP. In plan view, the plurality of concave portions RP in the semiconductor device DEV2 is arranged in a lattice-like arrangement. This lattice-like arrangement is, for example, a square-lattice arrangement. In this regard, the configuration of the semiconductor device DEV2 differs from the configuration of the semiconductor device DEV1. In plan view, the concave portion RP has, for example, a rectangular shape.

A pitch between two adjacent concave portions RP is defined as a pitch P. A minimum distance between the opposing side walls of the concave portion RP is defined as a width W. The pitch P is preferably larger than the width W. A value obtained by dividing the width W by the pitch P is preferably 0.1 or more and 0.4 or less. The concave portion RP is preferably formed at a position where it does not overlap the gate electrode EL2 in plan view. The gate electrode EL2 is at a position where it does not overlap the cell region in plan view.

### <Effects of Semiconductor Device DEV2>

There may be a case where wire bonding is performed on the source electrode EL1 and the gate electrode EL2. Since one relatively large concave portion RP is formed in the semiconductor device DEV1, when wire bonding is performed, a load is applied to the semiconductor substrate SUB such that the semiconductor substrate SUB flexes, and there is a risk of cracking of the semiconductor substrate SUB.

On the other hand, since relatively small concave portions are formed in the semiconductor device DEV2 in a lattice-like arrangement, the load applied at the time of wire bonding can be supported by the second surface SS between the concave portions RP. Therefore, according to the semiconductor device DEV2, it is possible to suppress cracking of the semiconductor substrate SUB caused by the load applied at the time of wire bonding.

In a case where the value obtained by dividing width W by the pitch P is 0.1 or more and 0.4 or less, it is possible to secure a strength against the load applied at the time of wire bonding while reducing the ON resistance associated with the formation of the concave portion RP.

In a case where the concave portion RP is arranged at a position where it does not overlap the gate electrode EL2 in plan view, it is possible to suppress cracking of the semiconductor substrate SUB caused by the load applied when wire bonding is performed on the gate electrode EL2. Since the gate electrode EL2 is at a position where it does no overlap the cell region R2 in plan view, the ON resistance hardly increases even if the concave portion RP is not formed at a position where it overlaps the gate electrode EL2 in plan view.

### <First Modification Example>

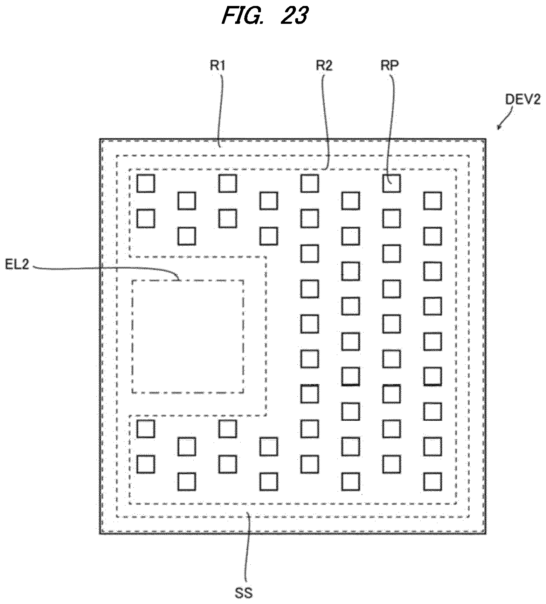

FIG. 23 is a bottom view of the semiconductor device DEV2 according to the first modification example. As shown in FIG. 23, the concave portion RP need not be arranged in a square-lattice manner. For example, the concave portion RP may be arranged in a staggered manner.

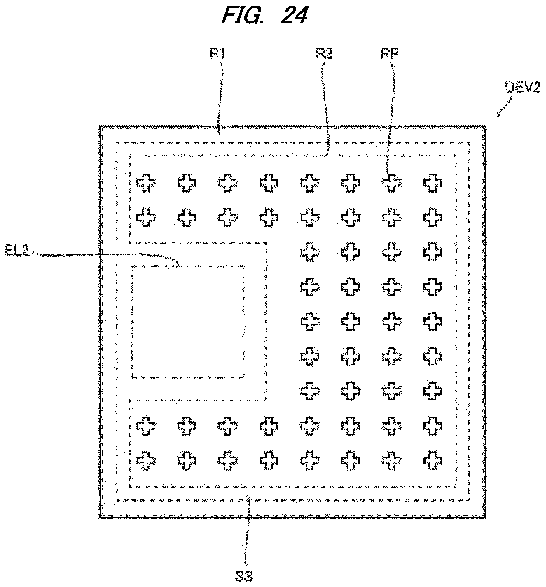

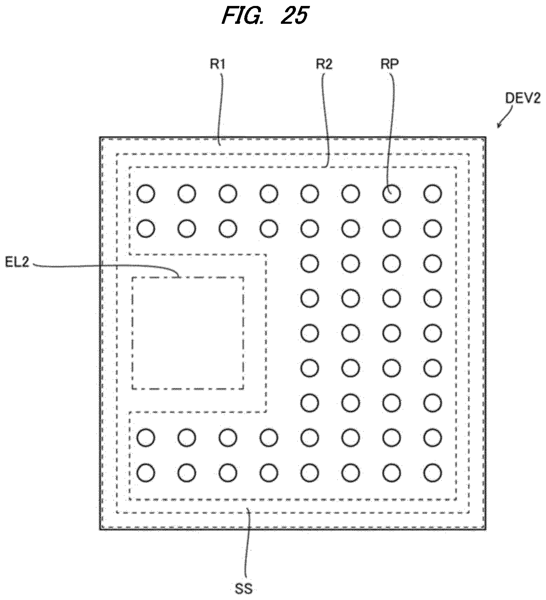

FIG. 24 is a bottom view of the semiconductor device DEV2 according to the second modification example. FIG. 25 is a bottom view of the semiconductor device DEV2 according to the third modification example. As shown in FIGS. 24 and 25, a planar shape of the concave portion RP need not be a rectangular shape. As shown in FIG. 24, the planar shape of the concave portion RP may be a polygonal shape other than a rectangular shape, and as shown in FIG. 25, the planar shape of the concave portion RP may be a circular (or elliptical) shape.

### (Third Embodiment)

Hereinafter, a semiconductor device according to a third embodiment (hereinafter referred to as "semiconductor device DEV3") will be described. Here, points that differ from the semiconductor device DEV1 will be mainly described, and redundant descriptions will be omitted as appropriate.

### <Configuration of Semiconductor Device DEV3>

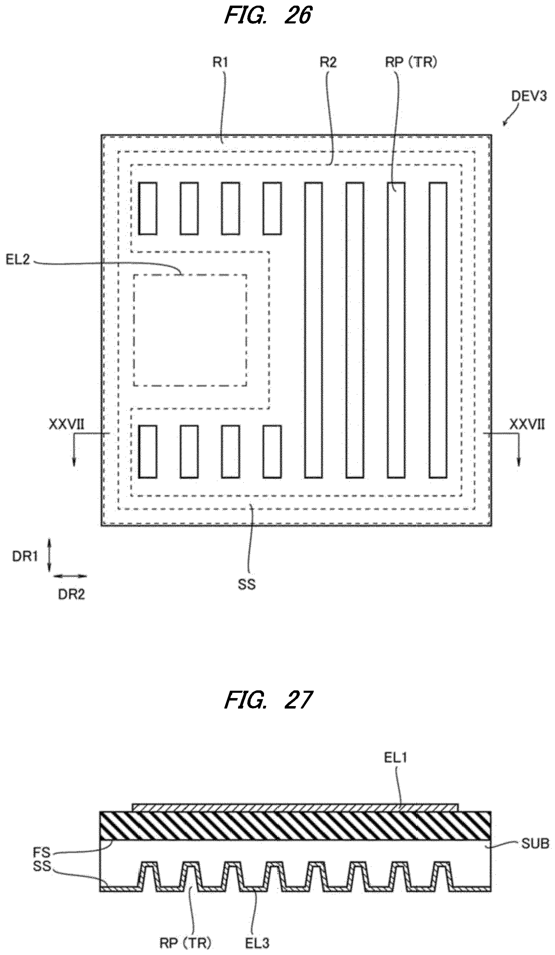

FIG. 26 is a bottom view of the semiconductor device DEV3. FIG. 27 is a cross-sectional view taken along a line XXVII-XXVII of FIG. 26. As shown in FIGS. 26 and 27, the semiconductor device DEV3 has the semiconductor substrate SUB, the gate insulating film GI, the gate GA, the interlayer insulating film ILD, the source electrode EL1, the gate electrode EL2, and the drain electrode EL3. In this regard, the configuration of the semiconductor device DEV3 is common to the configuration of the semiconductor device DEV1.

The semiconductor device DEV3 has a plurality of grooves TR formed as the concave portion RP. In this regard, the configuration of the semiconductor device DEV3 differs from the configuration of the semiconductor device DEV1.

In plan view, the grooves TR extend along a first direction DR1. The plurality of grooves TR are arranged so as to be spaced apart from each other in a second direction DR2. The second direction DR2 is a direction orthogonal to the first direction DR1. Each of the grooves TR is preferably formed at a position where it does not overlap the gate electrode EL2 in plan view.

In plan view, an extension direction of the gate trench GTR preferably extends along the first direction DR1. Namely, the extension direction of the gate trench GTR is preferably parallel to the extension direction of each of the grooves TR. However, the extension direction of the gate trench GTR may extend along the second direction DR2.

### <Effects of Semiconductor Device DEV3>

Since a plurality of grooves TR is formed in the semiconductor device DEV3, the load applied at the time of wire bonding can be supported by the second surface SS between the grooves TR. Therefore, according to the semiconductor device DEV3, it is possible to suppress cracking of the semiconductor substrate SUB caused by the load applied at the time of wire bonding. In a case where the extension direction of each of the grooves TR extends along the extension direction of the gate trench GTR, it is possible to further reduce the ON resistance.

### (Fourth Embodiment)

Hereinafter, a semiconductor device according to a fourth embodiment (hereinafter referred to as "semiconductor device DEV4") will be described. Here, points that differ from the semiconductor device DEV1 will be mainly described, and redundant descriptions will be omitted as appropriate.

### <Configuration of Semiconductor Device DEV4>

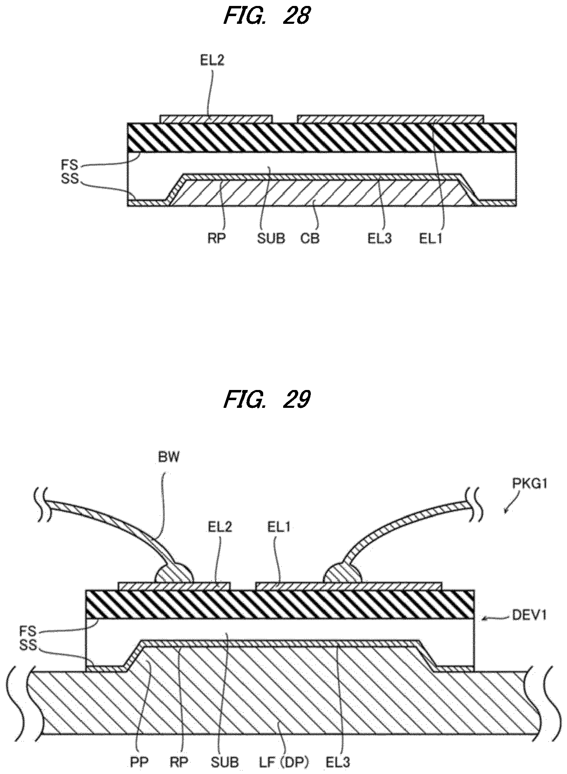

FIG. 28 is a cross-sectional view of the semiconductor device DEV4. As shown in FIG. 28, the semiconductor device DEV4 has the semiconductor substrate SUB, the gate insulating film GI, the gate GA, the interlayer insulating film ILD, the source electrode EL1, the gate electrode EL2, and the drain electrode EL3. In the cell region R2, the concave portion RP is formed in the second surface SS. In this regard, the configuration of the semiconductor device DEV3 is common to the configuration of the semiconductor device DEV1.

The semiconductor device DEV4 further has a conductor CB. In this regard, the configuration of the semiconductor device DEV4 differs from the configuration of the semiconductor device DEV1. The conductor CB is embedded in the concave portion RP. The conductor CB is formed of, for example, a sintered body of silver particles. However, the conductor CB is not limited to be formed of such of sintered body.

### <Effects of Semiconductor Device DEV4>

Since the conductor CB is embedded in the concave portion RP in the semiconductor device DEV3, the load applied at the time of wire bonding is also supported by the conductor CB. Therefore, according to the semiconductor device DEV4, it is possible to suppress cracking of the semiconductor substrate SUB caused by the load applied at the time of wire bonding.

### (Fifth Embodiment)

Hereinafter, a semiconductor package according to a fifth embodiment (hereinafter referred to as "semiconductor package PKG1") will be described.

### <Configuration of Semiconductor Package PKG1>

FIG. 29 is a cross-sectional view of the semiconductor package PKG1. As shown in FIG. 29, the semiconductor package PKG1 has the semiconductor device DEV1 and a lead frame LF. The lead frame LF has a die pad DP. The die pad DP has a convex portion PP. The lead frame LF is formed of, for example, copper, a copper alloy, or the like.

The semiconductor device DEV1 is arranged such that the second surface SS faces the lead frame LF (die pad DP). As a result, the convex portion PP is inserted into the concave portion RP. Although not shown, the drain electrode EL3 and the lead frame LF (die pad DP) are connected by, for example, solder. A bonding wire BW is connected to each of the source electrode EL1 and the gate electrode EL2.

### <Effects of Semiconductor Package PKG1>

In the semiconductor package PKG1, since the load applied at the time of wire bonding of the bonding wire BW to each of the source electrode EL1 and the gate electrode EL2 is also supported by the convex portion PP, it is possible to suppress cracking of the semiconductor substrate SUB caused by the load applied at the time of wire bonding.

### (Sixth Embodiment)

Hereinafter, a semiconductor package according to a sixth embodiment (hereinafter referred to as "semiconductor package PKG2") will be described.

### <Configuration of Semiconductor Package PKG2>

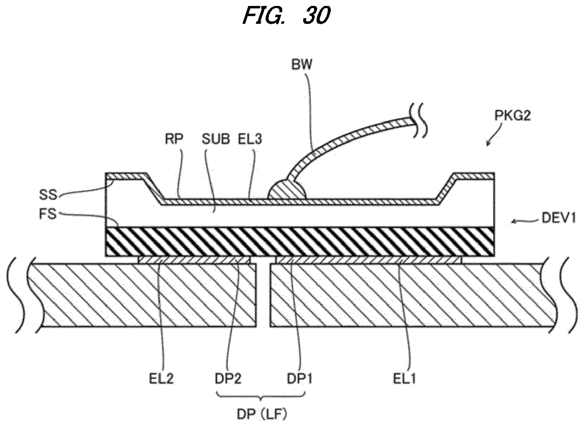

FIG. 30 is a cross-sectional view of the semiconductor package PKG2. As shown in FIG. 30, the semiconductor package PKG2 has the semiconductor device DEV1 and the lead frame LF. The lead frame LF has the die pad DP. The die pad DP is divided into a first portion DP1 and a second portion DP2.

The semiconductor device DEV1 is arranged such that the first surface FS faces the lead frame LF (die pad DP). The source electrode EL1 and the gate electrode EL2 are respectively connected to the first portion DP1 and the second portion DP2. The source electrode EL1 and the first portion DP1, and the gate electrode EL2 and the second portion DP2 are connected by, for example, solder (not shown). The bonding wire BW is connected to a portion of the drain electrode EL3 that is located on the bottom wall of the concave portion RP.

### <Effects of Semiconductor Package PKG2>

In the semiconductor package PKG2, since wire bonding is not performed on the source electrode EL1 and the gate electrode EL2, it is possible to suppress cracking of the semiconductor substrate SUB caused by the load applied at the time of wire bonding.

In the foregoing, the invention made by the present inventors has been concretely described based on the embodiments. However, it is needless to say that the present invention is not limited to the foregoing embodiments, and various modifications and alterations can be made within the scope of the present invention.

## Claims

1. A semiconductor device comprising:
a semiconductor substrate having a first surface and a second surface on an opposite side of the first surface;
a gate insulating film formed on the first surface;
a gate formed on the first surface via the gate insulating film;
a source region formed in the first surface side of the semiconductor substrate;
a body region formed so as to be in contact with the source region and including a channel region;
a drain region formed in the second surface side of the semiconductor substrate; and
a drift region formed so as to be in contact with the second surface side of the body region and the first surface side of the drain region,
wherein the gate faces the channel region with the gate insulating film interposed therebetween, and
wherein the semiconductor substrate has at least one concave portion formed in the second surface and being recessed toward the first surface.

2. The semiconductor device according to claim 1,
wherein the semiconductor substrate is formed of a single-crystal silicon, and
wherein the first surface and the second surface are orthogonal to a <100> direction of the single-crystal silicon.

3. The semiconductor device according to claim 1 or 2,
wherein a side wall of the at least one concave portion is at an angle of 50 degrees or more and 60 degrees or less with respect to the second surface.

4. The semiconductor device according to claim 1, 2, or 3,
wherein a side wall of the at least one concave portion is a surface orthogonal to a <111> direction of the single-crystal silicon.

5. The semiconductor device according to any one of claims 1 to 4,
wherein the at least one concave portion is a plurality of concave portions arranged in a lattice-like arrangement in plan view.

6. The semiconductor device according to claim 5,
wherein the plurality of concave portions each have a polygonal shape or a circular shape in plan view.

7. The semiconductor device according to claim 5 or 6, further comprising
a gate electrode formed on the first surface and electrically connected to the gate,
wherein the plurality of concave portions is at a position where the plurality of concave portions does not overlap the gate electrode in plan view.

8. The semiconductor device according to any one of claims 5 to 7,
wherein a value obtained by dividing a minimum distance between opposing side walls of the plurality of concave portions by a pitch between two adjacent concave portions is 0.1 or more and 0.4 or less.

9. The semiconductor device according to any one of claims 1 to 4,
wherein the at least one concave portion is a plurality of grooves extending along a first direction and arranged so as to be spaced apart from each other in a second direction intersecting the first direction.

10. The semiconductor device according to claim 9,
wherein a gate trench extending along the first direction in plan view is formed in the first surface,
wherein the channel region is exposed from a side wall of the gate trench, and
wherein the gate is formed inside the gate trench so as to face the channel region with the gate insulating film interposed therebetween.

11. The semiconductor device according to claim 9 or 10, further comprising
a gate electrode formed on the first surface and electrically connected to the gate,
wherein the plurality of grooves is at a position where the plurality of grooves does not overlap the gate electrode in plan view.

12. The semiconductor device according to any one of claims 1 to 11, further comprising
a conductor filled in the at least one concave portion.

13. The semiconductor device according to any one of claims 1 to 12,
wherein, at a position where the at least one concave portion is formed, a thickness of the drain region is smaller than a thickness of the drift region.

14. A semiconductor package comprising:
a lead frame; and
the semiconductor device according to any one of claims 1 to 13 arranged such that the second surface faces the lead frame, and
wherein the lead frame has at least one convex portion inserted in the at least one concave portion.

15. A semiconductor package comprising:
a lead frame; and
the semiconductor device according to any one of claims 1 to 13 arranged such that the first surface faces the lead frame side.
